# EUROPEAN PATENT APPLICATION

(11) **EP 2 653 949 A1**
(43) Date of publication of application: **23.10.2013**
(21) Application number: 12853729.7
(22) Date of filing: 02.05.2012
(51) Int. Cl.: G06F 1/20

(54) **MEMORY LIQUID-COOLING HEAT DISSIPATION METHOD, DEVICE AND SYSTEM**

(30) Priority: 30.11.2011 CN 201110390535
(71) Applicant: Huawei Technologies Co., Ltd., Shenzhen, Guangdong 518129 (CN)
(72) Inventor: YANG, Chengpeng, Shenzhen Guangdong 518129 (CN); PENG, Yaofeng, Shenzhen Guangdong 518129 (CN)
(74) Representative: Körber, Martin Hans
(86) International application number: PCT/CN2012/074993
(87) International publication number: WO 2013/078828

(57) **Abstract**

An embodiment of the present invention provides an apparatus for dissipating heat of a memory with liquid cooling. The apparatus includes: a liquid inlet pipe, a connection pipe, a liquid-cooling block, a liquid outlet pipe, and a main board, where the liquid inlet pipe, the liquid outlet pipe, and the liquid-cooling block are fixed on the main board; the liquid inlet pipe and the liquid outlet pipe are located at two ends of the liquid-cooling block respectively; a memory slot is further disposed on the main board, and the memory slot is adjacent to the liquid-cooling block; the liquid-cooling block is formed by a metal block, metal spring leaves fixed on two sides of the metal block, and a liquid channel that penetrates through the metal block; and the liquid inlet pipe, the liquid channel inside the metal block, and the liquid outlet pipe are connected by the connection pipe to form a cooling liquid loop. Accordingly, embodiments of the present invention further disclose a method and a system for dissipating heat of a memory with liquid cooling. By using the foregoing technical solutions, heat dissipation of a memory is implemented, and in addition, because the liquid-cooling block contacts a memory bank merely through the metal spring leaves, the memory bank may be conveniently plugged and unplugged without removing the liquid-cooling block during maintenance of the memory bank, thereby reducing a risk of cooling liquid leakage.

## Description

### TECHNICAL FIELD

The present invention relates to the computer field, and in particular, to a method, an apparatus, and a system for dissipating heat of a memory with liquid cooling.

### BACKGROUND

To deal with a rapidly-increasing amount of information, computing performance of servers and minicomputers must be continuously improved, and more components capable of faster computation are needed, which causes the amount of heat generated by a system to rapidly increase. At the same time, because volumes of servers and minicomputers are limited and components are compactly laid, heat density of the system is rapidly growing. Currently, system heat dissipation is a major bottleneck that restricts performance improvement of servers and minicomputers, while a traditional air cooling manner is already hard up before this problem. Liquid cooling, thanks to its outstanding heat dissipation performance, is favored by numerous enterprises and will become a major heat dissipation manner for servers and minicomputers.

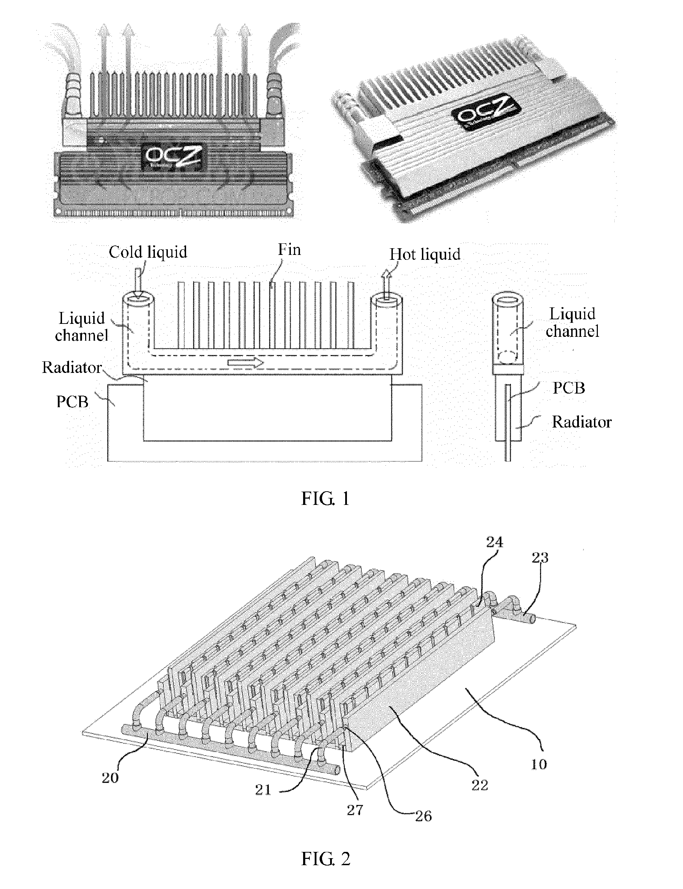

A memory, as a key component of a server or a minicomputer, contributes to more than 50% of generated heat, a temperature of the memory greatly affects its performance, and the memory is a component that must use liquid cooling to dissipate heat in a liquid-cooling architecture. Memories have relatively high thermal consumption and involve a large quantity, and a memory bank needs to be plugged and unplugged for many times during maintenance. Therefore, a well-designed memory liquid-cooling module is needed to meet the preceding requirement. FIG. 1 shows a structure of many memory liquid-cooling modules currently available on the market. This structure is characterized in that a liquid-cooling module is directly fixed on a PCB (Printed Circuit Board, printed circuit board), the liquid-cooling module is divided into two parts, namely, a radiator and a liquid channel, and heat generated by a memory is conducted to a metal radiator closely in contact with the memory and then absorbed and carried away by cooling liquid in the liquid channel.

In the prior art, a memory liquid-cooling module is directly fixed on a memory and the liquid-cooling module must be removed during maintenance of the memory. This causes inconvenient maintenance and a high risk of cooling liquid leakage when the liquid-cooling module is being removed.

### SUMMARY

Embodiments of the present invention provide a method, an apparatus, and a system for dissipating heat of a memory with liquid cooling, so that heat dissipation of a memory bank is implemented, and at the same time, maintenance of the memory bank is facilitated and a risk of cooling liquid leakage is reduced.

An embodiment of the present invention provides an apparatus for dissipating heat of a memory with liquid cooling. The apparatus includes: a liquid inlet pipe, a connection pipe, a liquid outlet pipe, a main board, and a liquid-cooling block and a memory slot that are disposed on the main board, where the liquid-cooling block is adjacent to the memory slot; the liquid inlet pipe and the liquid outlet pipe are installed on the main board and located at two ends of the liquid-cooling block; the liquid-cooling block includes: a metal block, metal spring leaves fixed on two sides of the metal block, and a liquid channel that penetrates through the metal block; the metal spring leaves are used to contact a memory bank in the memory slot and conduct heat that is generated during working of the memory bank to the metal block; and the connection pipe connects the liquid inlet pipe, the liquid channel, and the liquid outlet pipe to form a cooling liquid loop.

An embodiment of the present invention further provides a system for dissipating heat of a memory with liquid cooling. The system includes an apparatus for dissipating heat of a memory with liquid cooling and a memory bank; there are several memory granules on two sides of the memory bank; the apparatus for dissipating heat of a memory with liquid cooling includes: a liquid inlet pipe, a connection pipe, a liquid-cooling block, a liquid outlet pipe, a main board, and a memory slot; the memory bank is inserted in the memory slot; the liquid-cooling block is fixed on the main board and adjacent to the memory slot; the liquid inlet pipe and the liquid outlet pipe are installed at two ends of the liquid-cooling block; the liquid-cooling block includes: a metal block, metal spring leaves fixed on two sides of the metal block, and a liquid channel inside the metal block; the metal spring leaves are used to contact the memory bank that is inserted in the memory slot and conduct heat that is generated during working of the memory bank to the metal block; and the connection pipe connects the liquid inlet pipe, the liquid channel, and the liquid outlet pipe to form a cooling liquid loop.

An embodiment of the present invention further provides a method for dissipating heat of a memory with liquid cooling. The method includes:
disposing a liquid-cooling block at a position adjacent to a memory slot on a main board, where the liquid-cooling block is formed by a metal block, metal spring leaves fixed on two sides of the metal block, and a liquid channel that penetrates through the metal block;
conducting, by using the metal spring leaves, heat that is generated during working of a memory bank inserted in the memory slot to the metal block;
disposing a liquid inlet pipe and a liquid outlet pipe on the main board, and connecting the liquid inlet pipe, the liquid outlet pipe, and the liquid channel by using a connection pipe to form a cooling liquid loop; and
absorbing, by using cooling liquid in the cooling liquid loop, the heat that is conducted from the memory bank to the metal block.

In the technical solutions of the embodiments of the present invention, heat that is generated during working of a memory bank inserted in a memory slot of a main board is conducted by metal spring leaves on a liquid-cooling block that is adjacent to the memory slot to the liquid-cooling block, and then absorbed and carried away by cooling liquid in a cooling liquid loop that is formed by a liquid inlet pipe, a liquid channel inside the liquid-cooling block, and a liquid outlet pipe, thereby implementing heat dissipation of a memory. In addition, because the liquid-cooling block is fixed on the main board, relatively independent of the memory bank, and in contact with the memory bank merely through the metal spring leaves, the memory bank may be conveniently plugged and unplugged without removing a liquid-cooling module during maintenance of the memory bank, thereby reducing a risk of cooling liquid leakage.

### BRIEF DESCRIPTION OF DRAWINGS

To illustrate the technical solutions in the embodiments of the present invention or in the prior art more clearly, the following briefly introduces accompanying drawings required for describing the embodiments or the prior art. Apparently, the accompanying drawings in the following description show merely some embodiments of the present invention, and persons of ordinary skill in the art may still derive other drawings according to these accompanying drawings without creative efforts.

FIG. 1 is a schematic structural diagram of a memory liquid-cooling module in the prior art;

FIG. 2 is an overall structural diagram of an apparatus for dissipating heat of a memory with liquid cooling according to Embodiment 1 of the present invention;

FIG. 3 is a structural diagram of a liquid-cooling block of the apparatus for dissipating heat of a memory with liquid cooling according to Embodiment 1 of the present invention;

FIG. 4 is a side sectional view of the apparatus for dissipating heat of a memory with liquid cooling according to Embodiment 1 of the present invention;

FIG. 5 is a structural diagram of a system for dissipating heat of a memory with liquid cooling according to Embodiment 2 of the present invention; and

FIG. 6 is a flowchart of a method for dissipating heat of a memory with liquid cooling according to Embodiment 3 of the present invention.

### DESCRIPTION OF EMBODIMENTS

The following clearly and completely describes the technical solutions in the embodiments of the present invention with reference to the accompanying drawings in the embodiments of the present invention. Apparently, the embodiments to be described are merely a part rather than all of the embodiments of the present invention. All other embodiments obtained by persons of ordinary skill in the art based on the embodiments of the present invention without creative efforts shall fall within the protection scope of the present invention.

### Embodiment 1

Embodiment 1 of the present invention provides an apparatus for dissipating heat of a memory with liquid cooling. The apparatus is configured to dissipate heat of a memory. FIG. 2 is an overall structural diagram of an apparatus for dissipating heat of a memory with liquid cooling according to Embodiment 1 of the present invention. According to FIG. 2, the apparatus for dissipating heat includes a liquid inlet pipe 20, a connection pipe 21, a liquid outlet pipe 23, a main board 10, and a liquid-cooling block 22 and a memory slot 27 that are disposed on the main board 10. The liquid-cooling block 22 is adjacent to the memory slot 27, so that a memory bank may be closely in contact with the liquid-cooling block 22 after being inserted into the memory slot 27, thereby conducting heat to the liquid-cooling block 22.

In one embodiment, the liquid-cooling block 22 is located on a plane different from that of the main board 10, and is connected to one side of the main board 10. Specifically, as shown in FIG. 2, a plane where the liquid-cooling block 22 is located is vertical to a plane where the main board 10 is located. That is to say, in one embodiment, the liquid-cooling block 22 is vertically connected to one side of the main board 10; and certainly, it may be understood that, in another embodiment, a certain angle deviation may be allowed when the liquid-cooling block 22 is vertically connected to one side of the main board 10. For example, an included angle between the plane where the liquid-cooling block 22 is located and the plane where the main board 10 is located may have a deviation of about 0 to 15 degrees. For example, the included angle may be 91 degrees, 95 degrees, 85 degrees, 100 degrees, or the like.

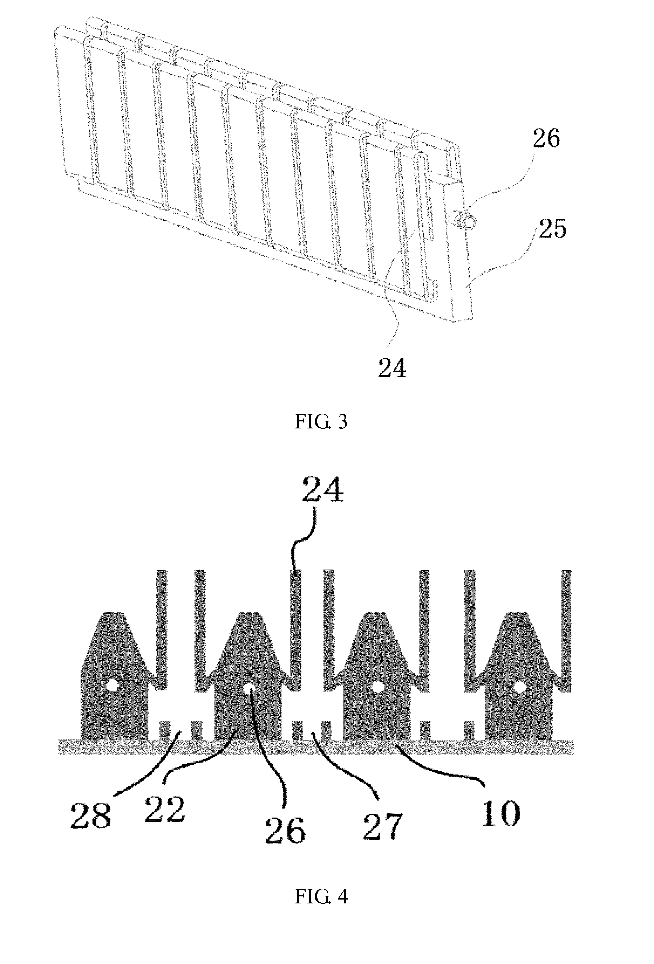

FIG. 3 shows a structure of the liquid-cooling block 22. According to FIG. 3, the liquid-cooling block 22 is mainly formed by a metal block 25, a liquid channel 26, and metal spring leaves 24. The metal spring leaves 24 are located on two sides of the metal block 25 and connected to the metal block 25. An internal liquid channel 26 is disposed in the metal block 25 to hold cooling liquid.

In one embodiment, the metal spring leaves 24 and the metal block 25 may be made of metal of relatively good thermal conductivity, such as iron, aluminum, copper, and the like.

In one embodiment, the metal spring leaves 24 and the metal block 25 are connected by using metal connectors or in a soldering manner.

In one embodiment, the metal spring leaves 24 may be made in a U shape, an O shape, or an arc shape.

It should be noted that in FIG. 2 according to this embodiment of the present invention, because no memory slot is disposed on one side of the liquid-cooling block 22, no metal spring leaf is disposed on the side of the liquid-cooling block 22. It may be understood that disposing metal spring leaves on only one side of the liquid-cooling block 22 is merely a special example of this embodiment of the present invention, and therefore, should not be construed as a limitation on the structure of the liquid-cooling block provided in this embodiment of the present invention.

The liquid inlet pipe 20 and the liquid outlet pipe 23 are fixed on the main board 10, and are located at two ends of the liquid-cooling block 22; and the liquid inlet pipe 20, the liquid channel 26 inside the liquid-cooling block 22, and the liquid outlet pipe 23 are connected by the connection pipe 21 to form a cooling liquid loop, so that the cooling liquid may flow from the liquid inlet pipe 20 into the liquid channel 26 inside the liquid-cooling block and then exit from the liquid outlet pipe 23.

In one embodiment, as shown in FIG. 2, the liquid inlet pipe 20 and the liquid outlet pipe 23 may be disposed on positions close to the two ends of the liquid-cooling block 22 on the main board 10 respectively, such as two edges corresponding to the two ends of the liquid-cooling block 22 on the main board 10.

In one embodiment, the connection pipe 21 connects the liquid inlet pipe 20, the liquid channel 26, and the liquid outlet pipe 23 by using connectors; and in another embodiment, the connection pipe 21 may also connect the liquid inlet pipe 20, the liquid channel 26, and the liquid outlet pipe 23 in a soldering manner.

In one embodiment, as shown in FIG. 2, multiple liquid-cooling blocks may be disposed on the main board 10, and accordingly, multiple connection pipes are also disposed. The multiple connection pipes connect the liquid inlet pipe 20, liquid channels inside the multiple liquid-cooling blocks, and the liquid outlet pipe 23 to form multiple cooling liquid loops.

FIG. 4 is a side sectional view of the apparatus for dissipating heat according to Embodiment 1 of the present invention. In one embodiment, multiple liquid-cooling blocks (such as 22 in FIG. 4) and multiple memory slots (such as 27 and 28 in FIG. 4) are disposed on the main board 10. As shown in FIG. 4, the liquid-cooling block 22 shown in FIG. 3 is fixed on the main board, adjacent to the memory slot 27, and located between two neighboring memory slots (such as memory slots 27 and 28 shown in the figure). In this way, after a memory bank is inserted in a memory slot, metal spring leaves are compressed and memory granules on two sides of the memory bank may closely contact the metal spring leaves of the liquid-cooling block, so that heat generated by the memory granules is conducted by the metal spring leaves to the liquid-cooling block and then absorbed and carried away by the cooling liquid in the liquid channel inside the liquid-cooling block.

In the technical solutions of this embodiment of the present invention, heat that is generated during working of a memory bank inserted in a memory slot of a main board is conducted by metal spring leaves on a liquid-cooling block that is adjacent to the memory slot to the liquid-cooling block, and then absorbed and carried away by cooling liquid in a cooling liquid loop that is formed by a liquid inlet pipe, a liquid channel inside the liquid-cooling block, and a liquid outlet pipe, thereby implementing heat dissipation of a memory. In addition, because the liquid-cooling block is fixed on the main board, relatively independent of the memory bank, and in contact with the memory bank merely through the metal spring leaves, the memory bank may be conveniently plugged and unplugged without removing a liquid-cooling module during maintenance of the memory bank, thereby reducing a risk of cooling liquid leakage.

### Embodiment 2

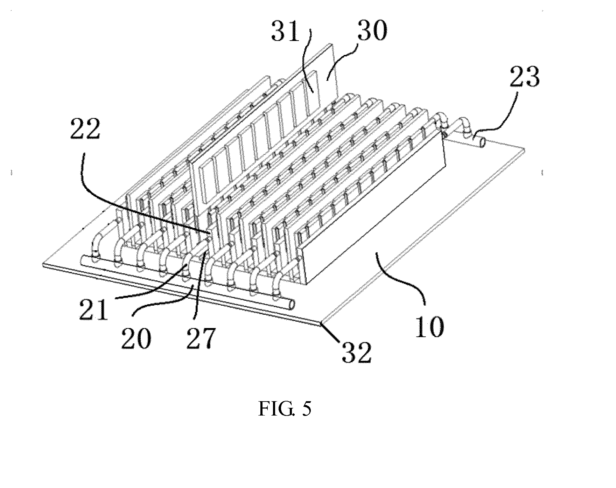

Embodiment 2 of the present invention provides a system for dissipating heat of a memory with liquid cooling. As shown in FIG. 5, the system includes an apparatus 32 for dissipating heat of a memory with liquid cooling and at least one memory bank (such as 30 in FIG. 5). There are several memory granules (such as 31 in FIG. 5) on two sides of the memory bank 30; and the apparatus 32 for dissipating heat of a memory with liquid cooling is formed by a liquid inlet pipe 20, a connection pipe 21, a liquid-cooling block 22, a liquid outlet pipe 23, and a main board 10. FIG. 3 shows a structure of the liquid-cooling block 22. According to FIG. 3, the liquid-cooling block 22 is mainly formed by a metal block 25, metal spring leaves 24 installed on two sides of the metal block, and a liquid channel 25 that penetrates through the metal block 25; and the liquid-cooling block 22 is fixed on the main board 10. The liquid inlet pipe 20 and the liquid outlet pipe 23 are installed on two sides of the liquid-cooling block 22. The liquid inlet pipe 20, a liquid channel 26 inside the liquid-cooling block 22, and the liquid outlet pipe 23 are connected by the connection pipe 21 to form a cooling liquid loop, so that cooling liquid may flow from the liquid inlet pipe 20 into the liquid channel 26 of the liquid-cooling block 22 and then exit from the liquid outlet pipe 23 while carrying away heat on the liquid-cooling block. At least one memory slot (such as 27 in FIG. 5) is further disposed on the main board 10, and the memory slot 27 is adjacent to the liquid-cooling block 22; the memory bank 30 is inserted in the memory slot 27, and the memory granules 31 on the memory bank 30 are closely in contact with the metal spring leaves 24. In this way, heat generated by the memory granules 31 is conducted by the metal spring leaves 24 to the metal block 25, and then absorbed and carried away by the cooling liquid in the liquid channel 26 inside the metal block 25.

In the technical solutions of this embodiment of the present invention, heat that is generated during working of a memory bank inserted in a memory slot of a main board is conducted by metal spring leaves on a liquid-cooling block that is adjacent to the memory slot to the liquid-cooling block, and then absorbed and carried away by cooling liquid in a cooling liquid loop that is formed by a liquid inlet pipe, a liquid channel inside the liquid-cooling block, and a liquid outlet pipe, thereby implementing heat dissipation of a memory. In addition, because the liquid-cooling block is fixed on the main board, relatively independent of the memory bank, and in contact with the memory bank merely through the metal spring leaves, the memory bank may be conveniently plugged and unplugged without removing a liquid-cooling module during maintenance of the memory bank, thereby reducing a risk of cooling liquid leakage.

The following describes a method of the present invention in detail by using a specific embodiment.

### Embodiment 3

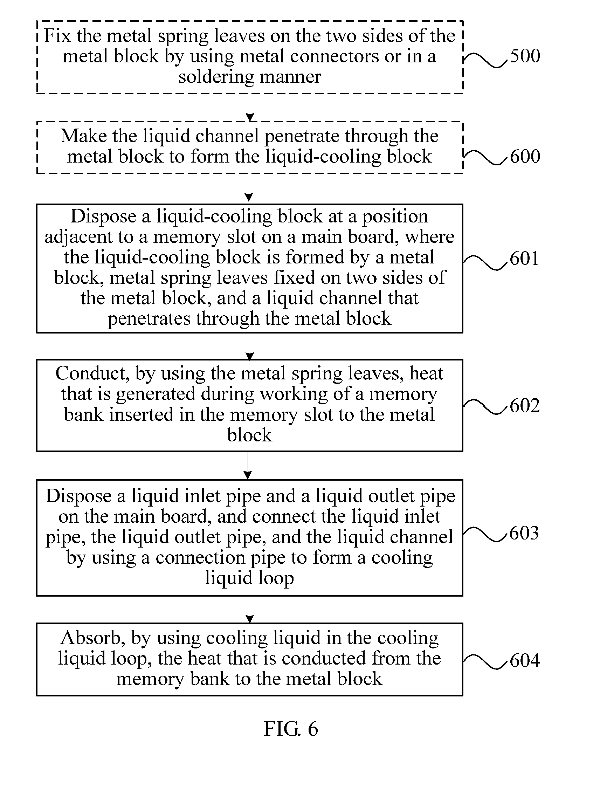

Embodiment 3 of the present invention provides a method for dissipating heat of a memory with liquid cooling. The method is used to dissipate heat of a memory inserted in a memory slot of a main board. As shown in FIG. 6, the method mainly includes:

Step 601: Dispose a liquid-cooling block at a position adjacent to a memory slot on a main board, where the liquid-cooling block is formed by a metal block, metal spring leaves fixed on two sides of the metal block, and a liquid channel that penetrates through the metal block.

Step 602: Conduct, by using the metal spring leaves, heat that is generated during working of a memory bank inserted in the memory slot to the metal block.

Step 603: Dispose a liquid inlet pipe and a liquid outlet pipe on the main board, and connect the liquid inlet pipe, the liquid outlet pipe, and the liquid channel by using a connection pipe to form a cooling liquid loop.

Step 604: Absorb, by using cooling liquid in the cooling liquid loop, the heat that is conducted from the memory bank to the metal block.

In one embodiment, as indicated by dashed line boxes shown in FIG. 6, the method may further include:

Step 500: Fix the metal spring leaves on two sides of the metal block by using metal connectors or in a soldering manner.

Step 600: Make the liquid channel penetrate through the metal block to form the liquid-cooling block.

In the technical solutions of this embodiment of the present invention, heat that is generated during working of a memory bank inserted in a memory slot of a main board is conducted by metal spring leaves on a liquid-cooling block that is adjacent to the memory slot to the liquid-cooling block, and then absorbed and carried away by cooling liquid in a cooling liquid loop that is formed by a liquid inlet pipe, a liquid channel inside the liquid-cooling block, and a liquid outlet pipe, thereby implementing heat dissipation of a memory. In addition, because the liquid-cooling block is fixed on the main board, relatively independent of the memory bank, and in contact with the memory bank merely through the metal spring leaves, the memory bank may be conveniently plugged and unplugged without removing a liquid-cooling module during maintenance of the memory bank, thereby reducing a risk of cooling liquid leakage.

Finally, it should be noted that the foregoing embodiments are merely intended for describing the technical solutions of the present invention rather than limiting the present invention. Although the present invention is described in detail with reference to the foregoing embodiments, persons of ordinary skill in the art should understand that they may still make modifications to the technical solutions described in the foregoing embodiments, or make equivalent replacements to part of the technical features of the technical solutions described in the foregoing embodiments; however, these modifications or replacements do not make the essence of the corresponding technical solutions depart from the scope of the technical solutions of the embodiments of the present invention

## Claims

1. An apparatus for dissipating heat of a memory with liquid cooling, comprising: a liquid inlet pipe, a connection pipe, a liquid outlet pipe, a main board, and a liquid-cooling block and a memory slot that are disposed on the main board, wherein the liquid-cooling block is adjacent to the memory slot; the liquid inlet pipe and the liquid outlet pipe are installed on the main board and located at two ends of the liquid-cooling block; the liquid-cooling block comprises: a metal block, metal spring leaves fixed on two sides of the metal block, and a liquid channel that penetrates through the metal block; the metal spring leaves are used to contact a memory bank in the memory slot and conduct heat that is generated during working of the memory bank to the metal block; and the connection pipe connects the liquid inlet pipe, the liquid channel, and the liquid outlet pipe to form a cooling liquid loop.

2. The apparatus according to claim 1, wherein a plane where the liquid-cooling block is located is vertical to a plane where the main board is located.

3. The apparatus according to claim 1, wherein the metal spring leaves and the metal block are made of iron, aluminum, or copper.

4. The apparatus according to claim 1, wherein the metal spring leaves are fixed on the metal block by using metal connectors or in a soldering manner.

5. The apparatus according to claim 1, wherein the metal spring leaves are in a U shape, an O shape, or an arc shape.

6. A system for dissipating heat of a memory with liquid cooling, comprising: an apparatus for dissipating heat of a memory with liquid cooling and a memory bank; wherein there are several memory granules on two sides of the memory bank; the apparatus for dissipating heat of a memory with liquid cooling comprises: a liquid inlet pipe, a connection pipe, a liquid-cooling block, a liquid outlet pipe, a main board, and a memory slot; the memory bank is inserted in the memory slot; the liquid-cooling block is fixed on the main board and adjacent to the memory slot; the liquid inlet pipe and the liquid outlet pipe are installed at two ends of the liquid-cooling block; the liquid-cooling block comprises: a metal block, metal spring leaves fixed on two sides of the metal block, and a liquid channel inside the metal block; the metal spring leaves are used to contact the memory bank that is inserted in the memory slot and conduct heat that is generated during working of the memory bank to the metal block; and the connection pipe connects the liquid inlet pipe, the liquid channel, and the liquid outlet pipe to form a cooling liquid loop.

7. The system according to claim 6, wherein the metal spring leaves are fixed on the metal block by using metal connectors or in a soldering manner.

8. The system according to claim 6, wherein the metal spring leaves are in a U shape, an O shape, or an arc shape.

9. A method for dissipating heat of a memory with liquid cooling, comprising:
disposing a liquid-cooling block at a position adjacent to a memory slot on a main board, wherein the liquid-cooling block is formed by a metal block, metal spring leaves fixed on two sides of the metal block, and a liquid channel that penetrates through the metal block;
conducting, by using the metal spring leaves, heat that is generated during working of a memory bank inserted in the memory slot to the metal block;
disposing a liquid inlet pipe and a liquid outlet pipe on the main board, and connecting the liquid inlet pipe, the liquid outlet pipe, and the liquid channel by using a connection pipe to form a cooling liquid loop; and
absorbing, by using cooling liquid in the cooling liquid loop, the heat that is conducted from the memory bank to the metal block.

10. The method according to claim 9, wherein before the disposing a liquid-cooling block at a position adjacent to a memory slot on a main board, the method further comprises:
fixing the metal spring leaves on the two sides of the metal block by using metal connectors or in a soldering manner; and
making the liquid channel penetrate through the metal block to form the liquid-cooling block.
